# EUROPEAN PATENT SPECIFICATION

(11) **EP 2 316 132 B1**
(45) Date of publication and mention of the grant of the patent: **01.02.2023**
(21) Application number: 09808285.2
(22) Date of filing: 13.08.2009
(51) Int. Cl.: H01L 29/786, G02F 1/1368, G09F 9/30, G09G 3/3258, G09G 3/36, H01L 27/12, H01L 29/24

(54) **FIELD EFFECT TRANSISTOR, DISPLAY ELEMENT, IMAGE DISPLAY DEVICE, AND SYSTEM**
FELDEFFEKTTRANSISTOR, ANZEIGEELEMENT, BILDANZEIGEVORRICHTUNG UND SYSTEM DAFÜR
TRANSISTOR À EFFET DE CHAMP, ÉLÉMENT D'AFFICHAGE, DISPOSITIF D'AFFICHAGE D'IMAGE ET SYSTÈME

(30) Priority: 20.08.2008 JP 2008211623; 03.08.2009 JP 2009180600
(43) Date of publication of application: 04.05.2011
(73) Proprietor: Ricoh Company, Ltd., Tokyo 143-8555 (JP)
(72) Inventor: UEDA, Naoyuki, Yokohama-shi Kanagawa 240-0044 (JP); ABE, Yukiko, Yokohama-shi Kanagawa 227-0055 (JP); KONDO, Hiroshi, Yokohama-shi Kanagawa 234-0051 (JP); NAKAMURA, Yuki, Machida-shi Tokyo 195-0053 (JP); SONE, Yuji, Yokohama-shi Kanagawa 227-0064 (JP)
(74) Representative: SSM Sandmair
(86) International application number: PCT/JP2009/064535
(87) International publication number: WO 2010/021349

(56) References cited:
- WO-A2-2006/051993
- WO-A2-2006/051993
- JP-A- 2000 228 516
- JP-A- 2000 228 516
- JP-B2- 3 618 131
- KWON Y ET AL: "Enhancement-mode thin-film field-effect transistor using phosphorus-doped (Zn,Mg)O channel", APPLIED PHYSICS LETTERS, A I P PUBLISHING LLC, US, vol. 84, no. 14, 5 April 2004 (2004-04-05) , pages 2685-2687, XP012061036, ISSN: 0003-6951, DOI: 10.1063/1.1695437

## Description

### TECHNICAL FIELD

The present invention relates to a field effect transistor, a display element, an image display device, and a system. More particularly, the present invention relates to a field effect transistor having an active layer formed of an oxide semiconductor, a display element and an image display device each including the field effect transistor, and a system having the image display device.

### BACKGROUND ART

A field effect transistor (FET) is a transistor for controlling a current flowing between a source electrode and a drain electrode by applying a voltage to a gate electrode to provide a gate for the flow of electrons or holes depending on an electric field of a channel.

An FET has been used as a switching element and an amplifying element for its characteristics. Since an FET shows a small gate current and has a flat profile, it can be easily manufactured or integrated compared to a bipolar transistor. Therefore, an FET is now an indispensable element in an integrated circuit used in electronic devices.

An FET has been applied as a thin film transistor (TFT) in an active matrix type display.

In recent years, liquid crystal displays, organic EL (electroluminescent) displays, electronic paper, and the like have been made into practical use as flat panel displays (FPDs).

FPDs are driven by a driver circuit including a TFT having an active layer formed of amorphous silicon or polycrystalline silicon. FPDs have been demanded to achieve further enlargement, higher definition, and a higher driving speed. In accordance with these demands, TFTs having higher carrier mobility, less characteristic change over time, and less characteristic variations in a panel have been demanded.

However, a TFT having an active layer formed of amorphous silicon (a-Si) or polycrystalline silicon (particularly low temperature polycrystalline silicon (LTPS)) has advantages and disadvantages. Therefore, it has been difficult to satisfy all the demands at the same time.

For example, a-Si TFT has disadvantages of insufficient mobility for driving a large screen LCD (Liquid Crystal Display) at a high speed, and a large shift of a threshold voltage in continuous driving. Although LTPS-TFTs have high mobility, they have a disadvantage in that threshold voltages largely vary due to a process for crystallizing an active layer by annealing using an excimer laser; therefore, a large-sized mother glass for the mass production line cannot be used.

Further, to realize a lightweight, flexible, highly shock resistant, and inexpensive display, a use of a flexible substrate such as a plastic film has been investigated.

In this case, in view of the heat resistance of the flexible substrate, it has been impossible to use silicon which requires a relatively high temperature process when manufactured.

To satisfy these demands, a TFT formed by using an oxide semiconductor, from which higher carrier mobility than amorphous silicon can be expected, has been actively developed (for example, see Patent Documents 1 to 5, and Non-patent Documents 1 and 2).

Patent Document 1 discloses a transparent semiconductor device which has a transparent channel layer formed of zinc oxide and the like to which a 3d transition metal element is doped and requires no thermal processing.

Patent Document 2 discloses a TFT having an active layer formed of ZnO.

Patent Documents 3 and 4 disclose a semiconductor device having a channel which includes one or more metal oxide including zinc (Zn)-gallium (Ga), cadmium (Ca)-gallium (Ga), and cadmium (Cd)-indium (In).

Patent Document 5 discloses a transparent thin film field effect transistor having an active layer formed of a homologous compound InMO₃(ZnO)ₘ (M = In, Fe, Ga, or Al, m = integer of 1 to 49) thin film.

Non-patent Document 1 discloses a TFT having a channel formed by using a single crystal InGaO₃(ZnO)₅.

Non-patent Document 2 discloses a TFT having an active layer formed by using an amorphous In-Ga-Zn oxide.

Non-patent Document 3 discloses a chemical state and optical and electrical properties of a MgIn₂O₄₋ₓ sintered body. Non-patent document 4 discloses MgIn₂O₄ having high electric conductivity. Document WO 2006/051993 A2 discloses an amorphous oxide applicable, for example, to an active layer of a TFT. The amorphous oxide comprises microcrystals.

Document KWON Y ET AL, "Enhancement-mode thin-film field-effect transistor using phosphorus-doped (Zn,Mg)O channel", APPLIED PHYSICS LETTERS, A I P PUBLISHING LLC, US, (20040405), vol. 84, no. 14, doi:10.1063/1.1695437, ISSN 0003-6951, pages 2685 - 2687, discloses enhancement-mode ZnO-based field-effect transistors that utilize an acceptor-doped channel. The active channel is polycrystalline ZnO doped with Mg, to increase the band gap, and P, to decrease the electron carrier concentration.

Document JP 3 618131 B2 relates to manufacturing of a thin film of MgIn₂ O₄ by an RF spattering method, and Li<+> ions are implanted to a thin film of a transparent oxide MgIn₂ O₄.

Document JP 2000 228516 A discloses transparent semiconductor bond comprising a laminated thin film having a structure in which an inorganic material layer containing composite oxide containing monovalent Cu such as CuAlO₂ or SrCu₂O₂, i.e., an inorganic oxide material and an n-type semiconductor layer showing an n-type conductive characteristic are laminated on a substrate.
[Patent Document 1] Japanese Patent Application Publication No. 2002-76356
[Patent Document 2] United States Patent No. 7067843
[Patent Document 3] Japanese Patent Application Publication No. 2007-529119
[Patent Document 4] United States Patent No. 7297977
[Patent Document 5] Japanese Patent Application Publication No. 2004-103957
[Non-patent Document 1] K. Nomura, and five others, "Thin-Film Transistor Fabricated in Single-Crystalline Transparent Oxide Semiconductor", SCIENCE, VOL.300, May 23, 2003, p.1269-1272
[Non-patent Document 2] K. Nomura, and five others, "Room-temperature fabrication of transparent flexible thin-film transistors using amorphous oxide semiconductors", NATURE, VOL.432, November 25, 2004, p.488-492
[Non-patent Document 3] Naoko Hikima, and four others, "New Transparent Electroconductive Oxide.2. Chemical States and Optical-Electrical Properties of Sintered MgIn2O4-x", The Japan Society of Applied Physics and Related Societies (The 39th Spring Meeting, 1992), Extended Abstracts, No.3, 30p-C-2, p.851
[Non-patent Document 4] N. Ueda, and six others, "New oxide phase with wide band gap and high electroconductivity, MgIn2O4", Appl. Phys, Lett. 61(16), 19, October, 1992, p.1954-1955

A TFT used in a driver circuit of a display is required to have what is called a normally-off characteristic. However, when ZnO, CdO, Cd-In oxide and Cd-Ga oxide are used for an active layer of the TFT, an oxygen vacancy or an interstitial metal atom is easily caused. As a result, an electronic carrier concentration is increased. Therefore, it has been difficult to achieve the normally-off characteristic.

In view of this, it has been suggested to dope a minute amount of metal for decreasing the electronic carrier concentration (see Patent Document 1). However, it has been difficult to uniformly dope the minute amount of metal to a wide area.

Moreover, the TFT disclosed in Patent Document 2 has a normally-off characteristic achieved by precisely controlling an amount of oxygen when depositing an active layer. However, this way has not been practical due to narrow process tolerances (margin).

As another important characteristic of a TFT, there is contact resistance between a source electrode and a drain electrode, and an active layer. The energy level of the conduction band minimum of Zn-Ga oxide is quite high in the semiconductor devices disclosed in Patent Documents 3 and 4. Therefore, it has been difficult to inject electron carriers and to obtain a favorable junction. (see Appl. Phys. Lett. 64, 1077 (1994))

Moreover, since a crystal structure of ZnO and In-Ga-Zn-O, which is a wurtz type and a homologous type, respectively (hexagonal system), is highly anisotropic, an orientation of the thin film is required to be controlled. Thus, it is expected to be difficult to apply this crystal structure to a large area display.

In view of the above circumstance, it has been suggested to make an active layer amorphous. However, ZnO is easily crystallized and the In-Ga-Zn-O is easily crystallized when a Zn concentration is increased to obtain high mobility.

Further, since the In-Ga-Zn-O is a system of ternary oxide, its composition cannot be easily controlled. Therefore, when the In-Ga-Zn-O is deposited by a sputtering method, there has been a disadvantage in that a film composition is largely deviated from a target composition.

Further, the In-Ga-Zn-O has rather high contact resistance between a source electrode and a drain electrode, and an active layer. Thus, there have been problems in that an on-current of a transistor is decreased due to a voltage drop caused by the contact resistance, and degradation of characteristics of the TFTs, such as variations in characteristics of the transistors, is easily caused, because the contact resistance of the respective TFTs varies.

In the present invention, a field effect transistor with high carrier mobility is provided, which is formed by using an active layer material mainly formed of two metal elements with a composition which is easily controlled, and has characteristics improved by suppressing the contact resistance between the source electrode and the drain electrode, and the active layer to be low.

Since the Mg-In oxide disclosed in Non-patent Documents 3 and 4 has high electrical conductivity, it has been inappropriate to use this Mg-In oxide as a material of a TFT.

However, through various repetitive experiments and the like, the present inventors found that it is possible to form a field effect transistor by using the Mg-In oxide to solve the problems mentioned above.

### DISCLOSURE OF INVENTION

The present invention, which is disclosed in the appended claim 1, has been made based on the above-described findings made by the present inventors.

According to one aspect of the present invention, a field effect transistor has the structure of claim 1.

### BRIEF DESCRIPTION OF DRAWINGS

Fig. 1 is a block diagram showing a configuration of a television apparatus according to an embodiment of the present invention;
Fig. 2 is a diagram for describing an image display device of Fig. 1;
Fig. 3 is a diagram for describing the image display device of Fig. 1;
Fig. 4 is a diagram for describing the image display device of Fig. 1;
Fig. 5 is a diagram for describing a display element;
Fig. 6 is a diagram for describing an organic EL element;
Fig. 7 is a diagram for describing a field effect transistor;
Fig. 8 is a diagram for describing characteristics of the field effect transistor of Embodiment 1;
Fig. 9 is a diagram for describing characteristics of the field effect transistor of a Comparison example 3;
Fig. 10 is a diagram for describing characteristics of the field effect transistor of a Comparison example 4;
Fig. 11 is a diagram for describing an arrangement of an organic EL element and a field effect transistor;
Fig. 12 is a diagram for describing a display control device;
Fig. 13 is a diagram for describing a Modified example of the arrangement of the organic EL element and the field effect transistor;
Fig. 14 is a diagram for describing a "bottom contact bottom gate type" field effect transistor;
Fig. 15 is a diagram for describing a "top contact top gate type" field effect transistor;
Fig. 16 is a diagram for describing a "bottom contact top gate type" field effect transistor;
Fig. 17 is a diagram for describing an arrangement example 1 of an organic EL element and a field effect transistor when the field effect transistor is the "top contact top gate type" field effect transistor;
Fig. 18 is a diagram for describing an arrangement example 2 of an organic EL element and a field effect transistor when the field effect transistor is the "top contact top gate type" field effect transistor;
Fig. 19 is a diagram for describing characteristics of the field effect transistor of Modified example 1;
Fig. 20 is a diagram for describing characteristics of the field effect transistor of Modified example 2;
Fig. 21 is a diagram for describing characteristics of the field effect transistor of Modified example 3;
Fig. 22 is a diagram for describing a liquid crystal display;
Fig. 23 is a diagram for describing a display element of Fig. 22;
Fig. 24 is a diagram for describing a field effect transistor of Comparison example 1;
Fig. 25 is a diagram for describing characteristics of a field effect transistor of Embodiment 2; and
Fig. 26 is a diagram for describing characteristics of a field effect transistor of Comparison example 2.

The present invention is represented by modified example 3. All other embodiments and modified examples define non-claimed technical background of the present invention.

### BEST MODE FOR CARRYING OUT THE INVENTION

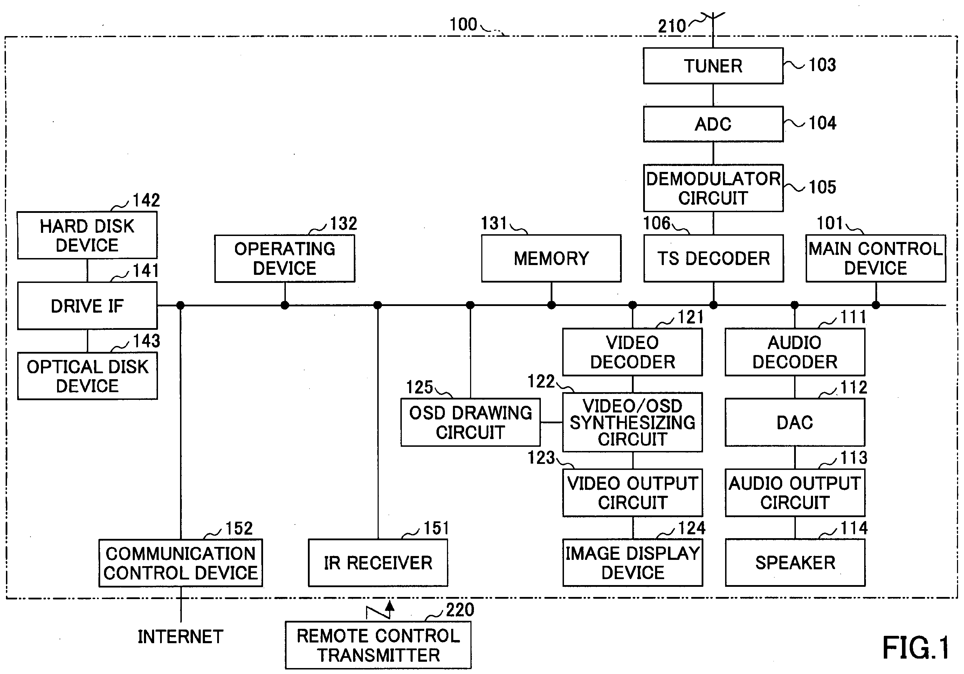

Embodiment 1 of the present invention is described below with reference to FIGS. 1 through 12. FIG. 1 shows a schematic configuration of a television apparatus 100, as a system according to Embodiment 1 of the present invention. Connecting lines in FIG. 1 indicate flows of representative signals and data, and do not show all connection relationships among the blocks.

The television apparatus 100 includes a main control device 101, a tuner 103, an AD (Analog-to-Digital) converter (ADC) 104, a demodulator circuit 105, a TS (Transport Stream) decoder 106, an audio decoder 111, a DA (Digital-to-Analog) converter (DAC) 112, an audio output circuit 113, a speaker 114, a video decoder 121, a video/OSD (operational sequence diagram) synthesizing circuit 122, a video output circuit 123, an image display device 124, an OSD drawing circuit 125, a memory 131, an operating device 132, a drive interface (drive IF) 141, a hard disk device 142, an optical disk device 143, an IR (Infrared) receiver 151, a communication control device 152, and the like.

The main control device 101 controls the entire television device 100 and is formed of a CPU, a flash ROM (Read Only Memory), a RAM (Random Access Memory), and the like. The flash ROM stores a program written in a code decodable by the CPU, various data used for the processes of the CPU, and the like. The RAM is a working memory (storage).

The tuner 103 selects a broadcast of a predetermined channel from broadcast waves received by the antenna 210.

The ADC 104 converts output signals (analog data) of the tuner 103 to digital data.

The demodulator circuit 105 demodulates the digital data outputted by the ADC 104.

The TS decoder 106 performs TS decoding of output signals of the demodulator circuit 105 and separates between audio data and video data.

The audio decoder 111 decodes audio data outputted by the TS decoder 106.

The DA converter (DAC) 112 converts the output signals of the audio decoder 111 to analog signals.

The audio output circuit 113 outputs the output signals of the DA converter (DAC) 112 to the speaker 114.

The video decoder 121 decodes the video data outputted by the TS decoder 106.

The video/OSD synthesizing circuit 122 synthesizes output signals of the video decoder 121 and the OSD drawing circuit 125.

The video output circuit 123 outputs the output signals of the video/OSD synthesizing circuit 122 to the image display device 124.

The OSD drawing circuit 125 includes a character generator for displaying text and a figure on a screen of the image display device 124, and generates signals including display data according to an instruction by the operating device 132 and the IR receiver 151.

The memory 131 temporarily accumulates AV (Audio-Visual) data and the like.

The operating device 132 includes, for example, an input medium (not shown in the drawing) such as a control panel, whereby various information inputted by a user are reported to the main control device 101.

The drive IF 141 is a bidirectional communication interface, which is compliant with, for example, ATAPI (AT Attachment Packet Interface).

The hard disk device 142 includes a hard disk, a driving device for driving the hard disk, and the like. The driving device records data in the hard disk and reproduces the data recorded in the hard disk.

The optical disk device 143 records data in an optical disc (such as a DVD (Digital Versatile Disc)) and reproduces the data recorded in the optical disc.

The IR receiver 151 receives optical signals from a remote control transmitter 220 and reports the received signals to the main control device 101.

The communication control device 152 controls a communication with the Internet. The communication control device 152 can acquire various kinds of information through the Internet.

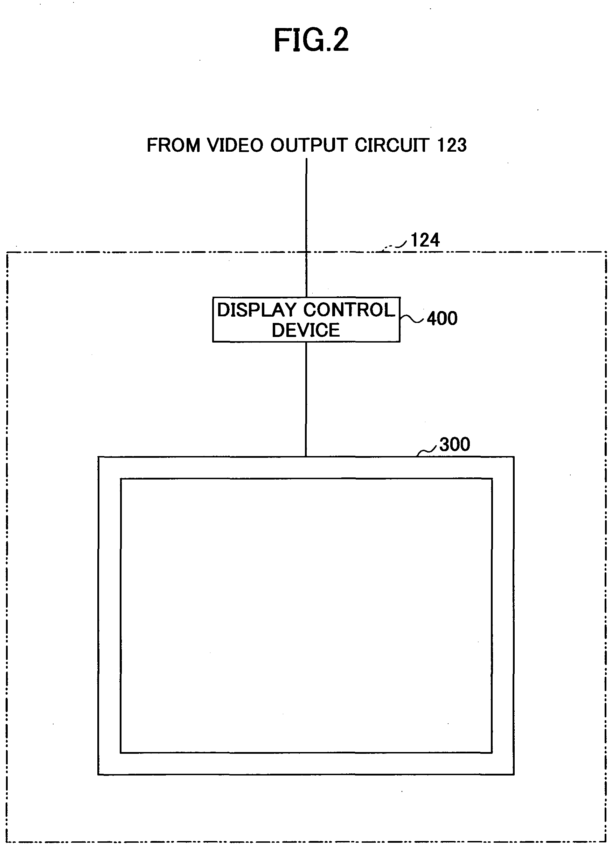

The image display device 124 includes, for example, a display device 300 and a display control device 400 as shown in FIG. 2.

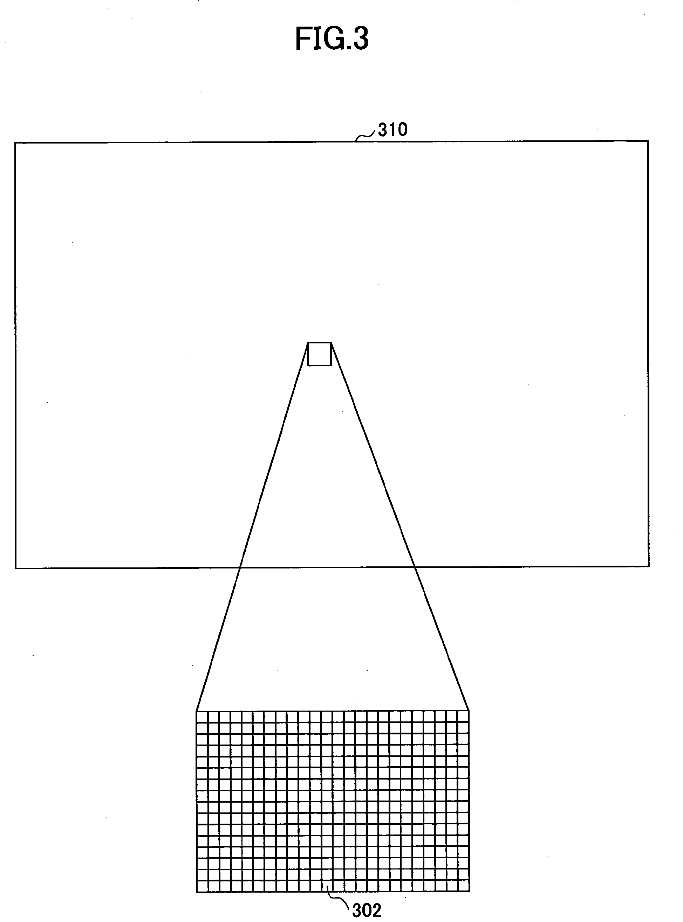

As shown in an example of FIG. 3, the display device 300 includes a display 310 in which plural (n × m here) display elements 302 are arranged in a matrix.

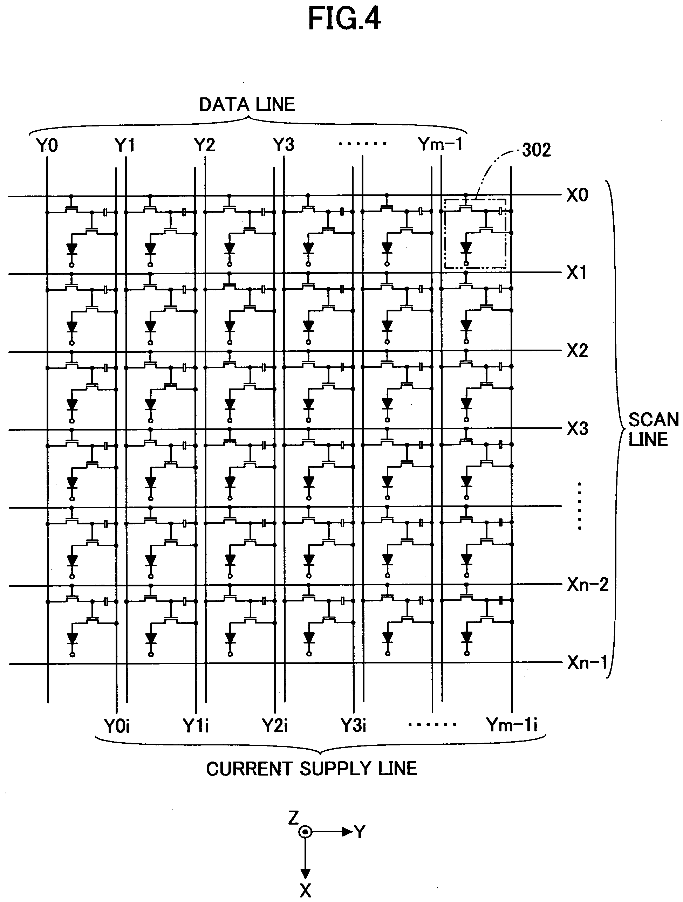

Further, as shown in an example of FIG. 4, the display 310 includes n scan lines (X0, X1, X2, X3, ... Xn-2, and Xn-1) arranged at an equal interval along an X axis direction, m data lines (Y0, Y1, Y2, Y3, ... and Ym-1) arranged at an equal interval along a Y axis direction, and m current supply lines (Y0i, Y1i, Y2i, Y3i, ... and Ym-1i) arranged at an equal interval along the Y axis direction. A display element can be specified by the scan line and the data line.

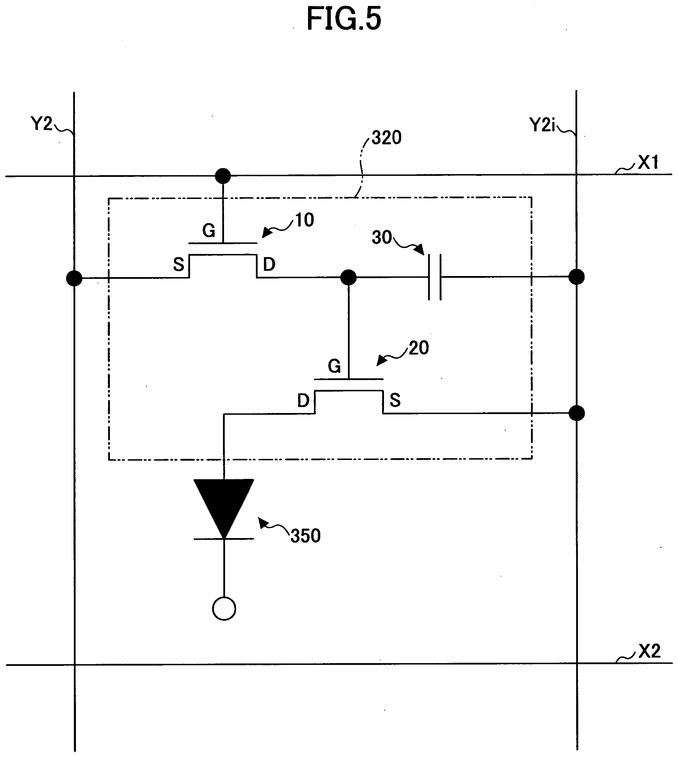

As shown in an example of FIG. 5, each display element includes an organic EL (electroluminescent) element 350 and a driver circuit 320 for causing the organic EL element 350 to emit light. That is, the display 310 is what is called an active matrix organic EL display. Moreover, the display 310 is a 32-inch color display, although the size of the display 310 is not limited to this.

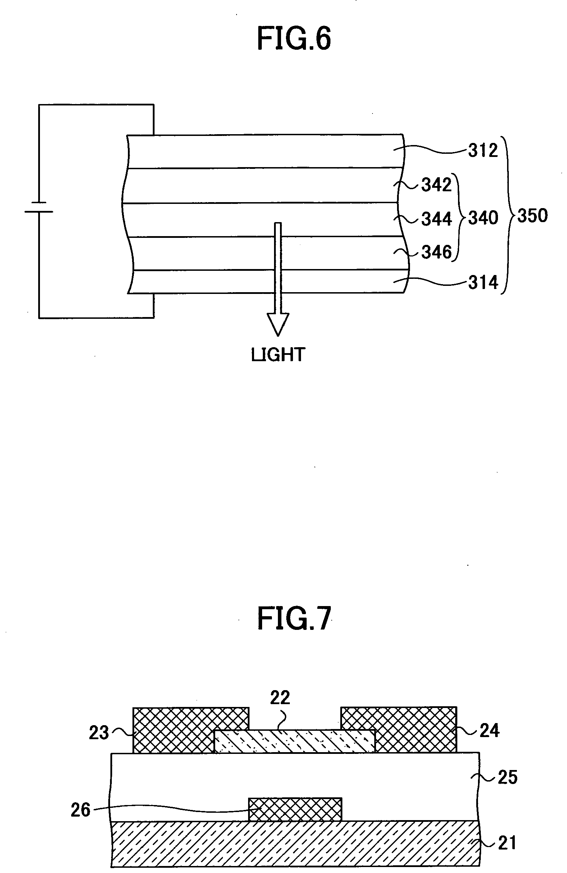

As shown in an example of FIG. 6, the organic EL element 350 includes an organic EL thin film layer 340, a cathode 312, and an anode 314.

The cathode 312 is formed by using aluminum (Al). The cathode 312 may be formed by using a magnesium (Mg)-silver (Ag) alloy, an aluminum (Al)-lithium (Li) alloy, ITO (Indium Tin Oxide), and the like.

The anode 314 is formed by using ITO. The anode 314 may be formed by using a conductive oxide such as In₂O₃, SnO₂, and ZnO, a silver (Ag)-neodymium (Nd) alloy, and the like.

The organic EL thin film layer 340 includes an electron transporting layer 342, a light emitting layer 344, and a hole transporting layer 346. The electron transporting layer 342 is connected to the cathode 312 while the hole transporting layer 346 is connected to the anode 314. The light emitting layer 344 emits light when a predetermined voltage is applied between the anode 314 and the cathode 312.

In FIG. 5, the driver circuit 320 includes two field effect transistors 10 and 20 and a capacitor 30.

The field effect transistor 10 operates as a switching element. The field effect transistor 10 has a gate electrode G connected to a predetermined scan line and a source electrode S connected to a predetermined data line. Further, a drain electrode D of the field effect transistor 10 is connected to one terminal of the capacitor 30.

The capacitor 30 serves to record a state of the field effect transistor 10, that is, data. The other terminal of the capacitor 30 is connected to a predetermined current supply line.

The field effect transistor 20 supplies a large current to the organic EL element 350. The field effect transistor 20 has a gate electrode G connected to the drain electrode D of the field effect transistor 10 and a drain electrode D connected to the anode 314 of the organic EL element 350. A source electrode S of the field effect transistor 20 is connected to a predetermined current supply line.

When the field effect transistor 10 is turned on, the organic EL element 350 is driven by the field effect transistor 20.

As shown in an example of FIG. 7, each of the field effect transistors 10 and 20 includes a substrate 21, an active layer 22, a source electrode 23, a drain electrode 24, a gate insulating layer 25, and a gate electrode 26.

Here, each of the field effect transistors 10 and 20 is what is called a "top contact bottom gate type" transistor.

A manufacturing method of the field effect transistor is briefly described below.
(1) Aluminum (Al) is deposited with a thickness of 100 nm over a glass substrate 21. By performing photolithography, the deposited aluminum is patterned into a line to form the gate electrode 26.
(2) By performing plasma CVD (Chemical Vapor Deposition), SiO₂ is deposited with a thickness of 200 nm over the substrate to form the gate insulating film 25.
(3) A resist is applied over the gate insulating film 25 and exposure and development are performed onto the substrate having the resist on it. Accordingly, a resist layer patterned into a shape corresponding to the active layer 22 is formed.
(4) By performing a radio frequency sputtering method, a Mg-In oxide film serving as the active layer 22 is formed.
   Here, a polycrystalline sintered body (with a diameter of 4 inches) having a In₂MgO₄ composition was used as a target of the sputtering. The back pressure in a sputtering chamber was set at 2 × 10⁻⁵ Pa. A flow rate of an argon gas and an oxygen gas supplied in sputtering was controlled so that the total pressure becomes 0.3 Pa and the oxygen partial pressure becomes 1.7 × 10⁻³ Pa. During the sputtering process, a holder holding the substrate 21 was cooled by water so as to control the temperature of the substrate 21 to be 15 to 35°C. By performing the sputtering with a sputtering power of 150 W for 30 minutes, the Mg-In oxide film with a thickness of 100 nm was formed.
(5) By performing a liftoff process by removing the resist, the active layer 22 is formed into a desired shape.
(6) By performing a photolithography and a liftoff method, a source electrode and a drain electrode are formed of aluminum (Al) with a thickness of 100 nm. Here, a channel length was set to be 50 µm and a channel width was set to be 2 mm.

When volume resistivity of the Mg-In oxide film deposited on the glass substrate with the same conditions as described above was measured, it was 10 Ωcm. Further, when the Mg-In oxide film was scanned by a Kα line of copper (Cu) (incident angle = 1°, 20 = 10° to 70°) by using an X-ray grating apparatus equipped with a parallel optical system, a sharp peak indicating crystallinity was not observed, and thus it was confirmed that the formed film was in an amorphous state.

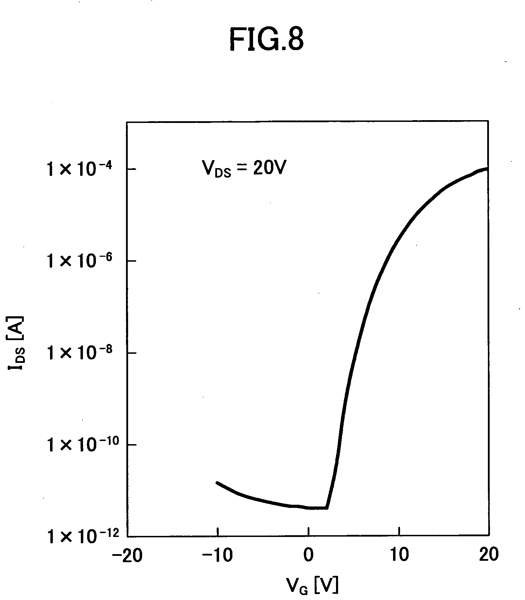

The field effect transistor manufactured by the manufacturing method as described above was a typical n-type transistor having electrons as carriers. FIG. 8 shows a relationship between a gate electrode V_{G} and a source-drain current I_{DS} when a source-drain voltage V_{DS} was 20 V in this field effect transistor. Accordingly, when the gate voltage V_{G} was 1 V, the source-drain current I_{DS} was 4 pA, which is a minimum value. When the gate voltage V_{G} was 0 V, the source-drain current I_{DS} was a value close to the minimum value. That is, this field effect transistor exhibits a favorable normally-off characteristic.

When the gate voltage V_{G} was 20 V, the source-drain current I_{DS} (current flowing between the source and drain) was 90 µA. Field effect mobility calculated in a saturation region was 2.1 cm²/Vs.

That is, the field effect transistor of this embodiment has high carrier mobility and a normally-off characteristic.

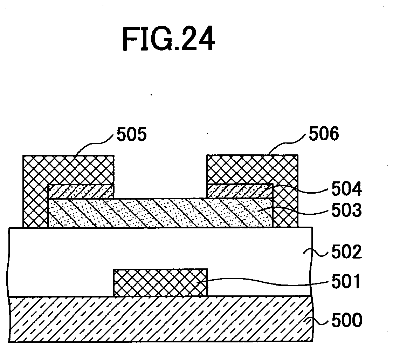

As Comparison example 1, a field effect transistor having an active layer formed of amorphous silicon as shown in Fig. 24 was manufactured by performing the following steps.
(1) Molybdenum (Mo) was sputtered with a thickness of 200 nm on a glass substrate 500. By patterning the formed film into a line by photolithography, a gate electrode 501 was formed.
(2) By plasma CVD, three layers of SiNx to be a gate insulating film 502, amorphous silicon (a-Si:H) to be an active layer 503, and amorphous silicon 504 (n⁺-a-Si:H) to which phosphorus was doped were sequentially deposited. Film thicknesses of the three layers were 300 nm, 200 nm, and 50 nm, respectively. The active layer 503 was deposited with the substrate temperature of 250°C, the SiH₄ flow rate of 35 sccm, the H₂ flow rate of 35 sccm, the pressure of 0.1 Torr, and the power density of 100 mW/cm². n⁺-a-Si:H was provided to improve the contact between the active layer 503, and the source and drain electrodes 505 and 506. Subsequently, a TFT was formed into an island by photolithography.
(3) An aluminum (Al) layer with a thickness of 100 nm was formed. This aluminum layer was patterned by photolithography into the shapes of the source electrode 505 and the drain electrode 506.
(4) A back channel was formed by reactive ion etching (RIE) by using the source and drain electrodes 505 and 506 as masks. By this etching, n⁺-a-Si:H between the source electrode and the drain electrode (channel part) was removed, and a field effect transistor shown in Fig. 24 was obtained. A channel length and a channel width of the transistor were set 50 µm and 0.2 mm, respectively.

The above-described field effect transistor exhibits characteristics of a typical n-type transistor. When a source-drain voltage (voltage between the source and drain) V_{DS} is 10 V, the transistor is in an off state and a source-drain current I_{DS} was about 10 pA when a gate voltage V_{G} = 0 V. Further, in the case where V_{G} = 20 V, I_{DS} was 3 µA, and field effect mobility calculated in a saturation region was 0.3 cm²/Vs.

By the above-described Embodiment 1 and Comparison example 1, it was shown that a field effect transistor having an active layer formed of a Mg-In oxide film can achieve higher carrier mobility than a typical transistor having an active layer formed of a-Si.

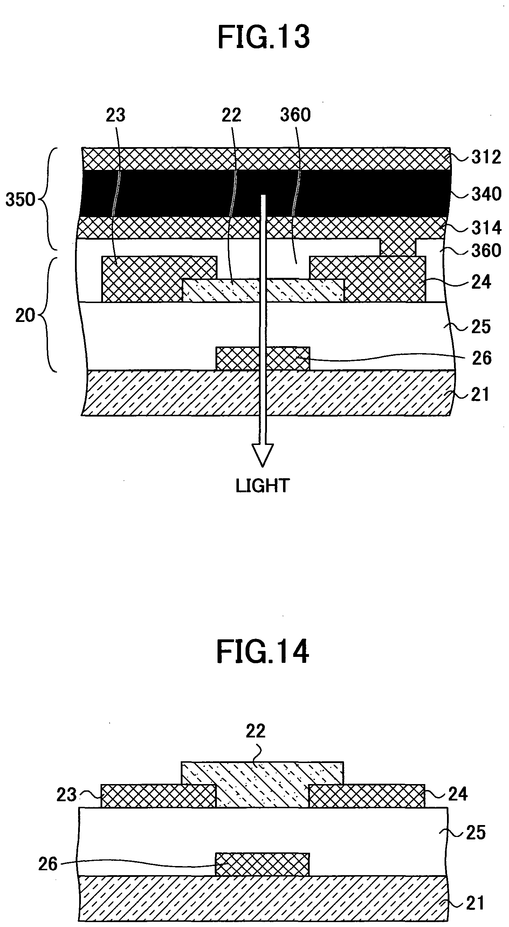

As Embodiment 2 of the present invention, a bottom gate bottom contact type transistor as shown in Fig. 14 was manufactured by the following steps.
(1) Aluminum (Al) was deposited with a thickness of 100 nm by vapor deposition on a glass substrate 21. By patterning the deposited film into a line by photolithography, a gate electrode 26 was formed.
(2) SiO₂ was deposited with a thickness of 200 nm by plasma CVD to form a gate insulating film 25.
(3) By a DC sputtering method, an ITO film to serve as a source electrode 23 and a drain electrode 24 was formed. Then, the ITO film was patterned into desired electrode shapes by photolithography.
(4) By application, exposure, and development of a resist, a resist layer patterned into a shape corresponding to an active layer 22 was formed.
(5) By a radio frequency sputtering method, a Mg-In oxide film to serve as the active layer 22 was formed. Conditions for deposition which were similar to those of Embodiment 1 were employed.
(6) A lift-off process is performed by removing the resist, to form the active layer 22 into a desired shape. Since the conditions for depositing the Mg-In oxide film are the same as those of Embodiment 1, the Mg-In oxide film of Embodiment 2 is also in an amorphous state and has a volume resistivity of about 10 Ωcm.

By performing the above-described steps, a field effect transistor with a channel length of 5 µm and a channel width of 1.5 mm was obtained. Further, by repeating the same steps, four samples of this field effect transistor were manufactured.

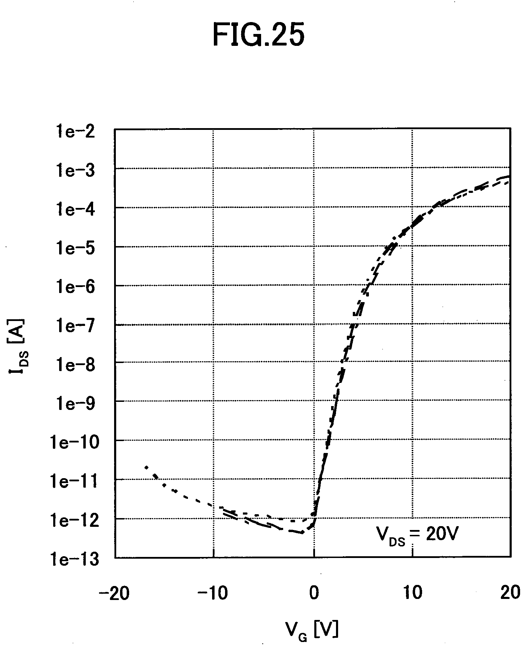

A relationship of a gate voltage V_{G} and a source-drain current I_{DS} of each of these four field effect transistors in the case where a source-drain voltage V_{DS} is 20 V is shown in Fig. 25. The characteristics of the four transistors, which are shown by one solid line and three broken lines with different patterns, match well with each other,which means that the transistors with favorable characteristics are realized with good reproducibility. Field effect mobility calculated in a saturation region was 0.8 to 1.1 cm²/Vs.

Further, contact resistance between the source electrode and the active layer, and between the drain electrode and the active layer was about 2 kΩ.

As Comparison example 2, a field effect transistor was manufactured in a similar manner to Embodiment 2 except that an amorphous In-Ga-Zn oxide was used as a material for forming an active layer.

The In-Ga-Zn oxide film was deposited by a DC sputtering method. As a target, a polycrystalline sintered body (with a diameter of 4 inches) having a composition of InGaZnO₄ was used. The back pressure in a sputtering chamber was set at 2 × 10⁻⁵ Pa. Flow rates of an argon gas and an oxygen gas supplied in sputtering were controlled so that the total pressure becomes 0.7 Pa and the oxygen partial pressure becomes 1.16 × 10⁻² Pa. During the sputtering, the temperature of the substrate 21 was controlled to be within a range of 15 to 35°C by cooling a holder holding the substrate 21 with water. The In-Ga-Zn oxide film with a thickness of 100 nm was formed by setting a sputtering power to be 140 W and sputtering time to be 30 minutes.

A field effect transistor with a channel length of 5 µm and a channel width of 1.5 mm was obtained by the steps similar to those of Embodiment 2. Further, by repeating the same steps, four samples of this field effect transistor were manufactured.

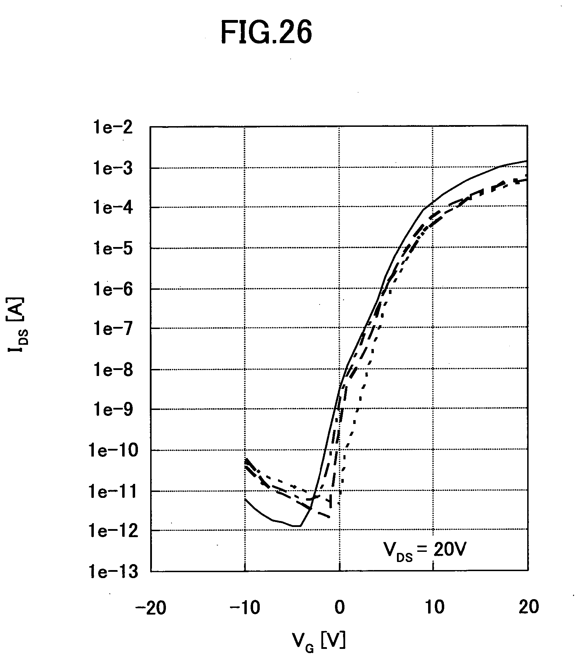

A relationship of a gate voltage V_{G} and a source-drain current I_{DS} of each of these four field effect transistors in the case where a source-drain voltage V_{DS} is 20 V is shown in Fig. 26. The characteristics of the four transistors, which are shown by one solid line and three broken lines with different patterns, clearly vary. For example, there are large differences among the samples in the current value obtained when the transistors are on. Field effect mobility calculated in a saturation region vary from 0.8 to 3.0 cm²/Vs.

Contact resistance between the source electrode and the active layer and between the drain electrode and the active layer were about 50 kΩ. On the other hand, resistance of a channel (channel resistance) in the case where the transistor is on (for example, V_{G} = 20V) is estimated to be about 5 kΩ. In this sample, the contact resistance has a large effect because the contact resistance is higher than the channel resistance. Thus, the characteristics of this sample are unstable. The contact resistance tends to vary depending on the samples, which is a cause of varied characteristics of the transistors.

By the above-described Embodiment 2 and Comparison example 2, it was shown that using the Mg-In oxide as the active layer can reduce the contact resistance by an order of magnitude or more than the In-Ga-Zn oxide, and transistors with uniform characteristics can be obtained.

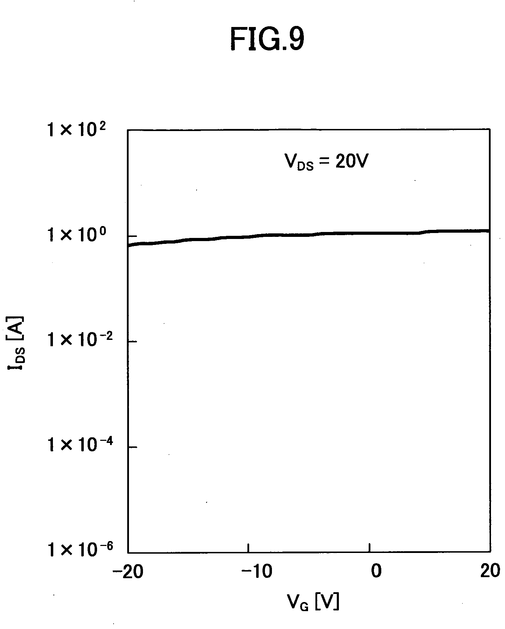

As Comparison example 3, a field effect transistor was manufactured in a manner similar to Embodiment 1 except that the oxygen partial pressure for sputtering the Mg-In oxide film was set to be 1.3 × 10⁻³ Pa, which is smaller than the oxygen partial pressure of the above-described manufacturing method. In the field effect transistor of the Comparison example 3, a relationship between a gate voltage V_{G} and a source-drain current I_{DS} when a source-drain voltage V_{DS} is 20 V is shown in FIG. 9. Accordingly, even when the gate voltage V_{G} is changed from -40 to 20 V, there is quite a small change in the source-drain current I_{DS}. Thus, an off state could not be achieved in this range of the gate voltage V_{G}. Volume resistivity of the Mg-In oxide film formed with these conditions was 4 × 10⁻³ Ωcm.

After various experiments, it was found that as the oxygen partial pressure for sputtering the Mg-In oxide film was decreased, the volume resistivity of the Mg-In oxide film was decreased and a threshold voltage of the manufactured field effect transistor was shifted to a negative direction (decreased). Through examination of a relationship between the volume resistivity of the Mg-In oxide film and a normally-off characteristic, it was found that the normally-off characteristic cannot be achieved when the volume resistivity of the Mg-In oxide film is less than 10⁻² Ωcm.

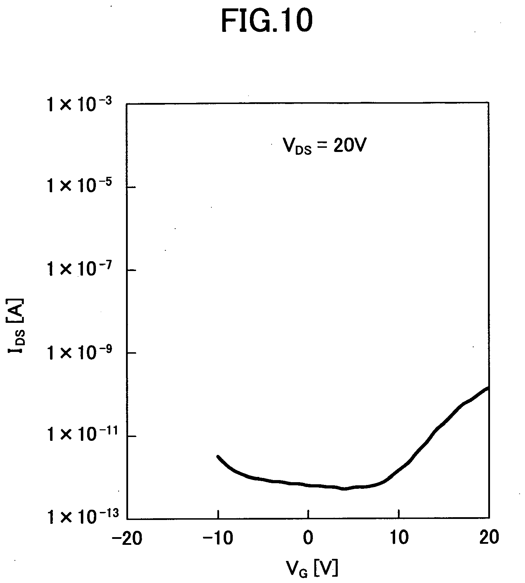

As a Comparison example 4, a field effect transistor was manufactured in a manner similar to Embodiment 1 except that the partial oxygen pressure for sputtering the Mg-In oxide film was set to be 5.0 × 10⁻³ Pa, which is higher than the partial oxygen pressure of the above-described manufacturing method. In the field effect transistor of the Comparison example 4, a relationship between a gate voltage V_{G} and a source-drain current I_{DS} when a source-drain voltage V_{DS} is 20 V is shown in FIG. 10. Accordingly, when the gate voltage V_{G} is 5 V, the source-drain current I_{DS} is 0.5 pA, which is a minimum value. When the gate voltage V_{G} is 20 V, I_{DS} = 0.14 nA. Field effect mobility calculated in a saturation region was 7 × 10⁻⁶ cm²/Vs, which was smaller than a value required as a field effect transistor. Volume resistivity of the Mg-In oxide film formed with these conditions was 2 × 10⁹ Ωcm.

Through various experiments, it was found that as the oxygen partial pressure for sputtering the Mg-In oxide film is increased, the volume resistivity of the obtained Mg-In oxide film is increased, and a value of an on-current and field effect mobility of the manufactured field effect transistor tend to be decreased. As a result of considering a relationship between the volume resistivity and the field effect mobility of the Mg-In oxide film, it was found that when the volume resistivity of the Mg-In oxide film becomes higher than 10⁹ Ωcm, the field effect mobility becomes lower than 1 × 10⁻⁵ cm²/Vs and transistor characteristics are degraded to such a level that is unsuitable for practical uses.

Table 1 shows volume resistivity of the Mg-In oxide film serving as the active layer and transistor characteristics, of the transistors of Embodiments 1 and 2, Comparison examples 3 and 4, and Modified examples 1 through 3.

**Table 1**

| | Volume Resistivity [Ω cm] of Active Layer | Characteristics of Active Layer | Structure of Transistor | ON-OFF Characteristics | Carrier Mobility [cm²/Vs] |
|---|---|---|---|---|---|
| Comparison example 3 | 4 × 10⁻³ | Amorphous Deposited with low oxygen partial pressure | Bottom gate top contact | Not turned off | - |
| Modified example 3 | 9 | A part of Mg is substituted with Sr | Bottom gate top contact | Normally-off | 2.6 |
| Embodiment 1 | 10 | Amorphous | Bottom gate top contact | Normally-off | 2.1 |
| Embodiment 2 | 10 | Amorphous | Bottom gate bottom contact | Normally-off | 0.8 to 1.1 |
| Modified example 1 | 40 | Crystalline | Bottom gate top contact | Normally-off | 2.6 |
| Modified example 2 | 1100 | A part of In is substituted with Ga | Bottom gate top contact | Normally-off | 1.3 |
| Comparison example 4 | 2 × 10⁹ | Amorphous Deposited with high oxygen partial pressure | Bottom gate top contact | Normally-off | 7 × 10⁻⁶ |

To achieve the normally-off characteristics and high carrier mobility, it is preferable that the volume resistivity of the Mg-In oxide film to serve as the active layer be set at 10⁻² to 10⁹ Ωcm.

The resistivity depends mainly on the carrier density and mobility. Therefore, the resistivity can be controlled by changing the carrier density and mobility intentionally. To control the resistivity of the Mg-In oxide film, it is effective to change the carrier density by controlling the amount of oxygen (density of oxygen defect) in the Mg-In oxide film. As described above, the resistivity of the formed film changes by changing the oxygen partial pressure employed in the sputtering deposition. In the case of forming a film by a method other than sputtering as well, a film with desired resistivity can be formed by controlling an atmosphere of the process. Further, since the resistivity is also changed by annealing performed after the film is formed, it is also effective to optimize the annealing temperature or atmosphere. Alternatively, the resistivity can also be changed by substituting a part of the each element that constitutes the Mg-In oxide film with another element.

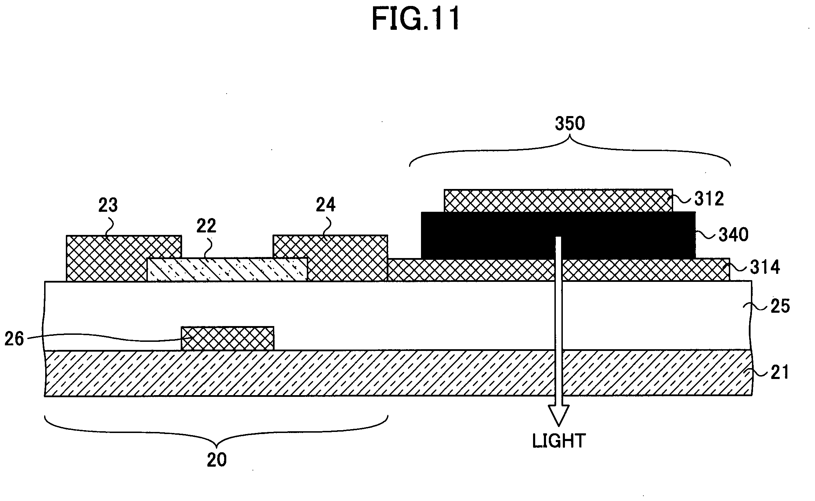

FIG. 11 shows a positional relationship between the organic EL element 350 of the display element 302 and the field effect transistor 20 described in Embodiment 1. Here, the organic EL element 350 is arranged beside the field effect transistor 20. The field effect transistor 10 and the capacitor 30 are formed on the same substrate as these elements.

The display element 302 can be manufactured by using an apparatus and steps (manufacturing process) similar to the conventional ones.

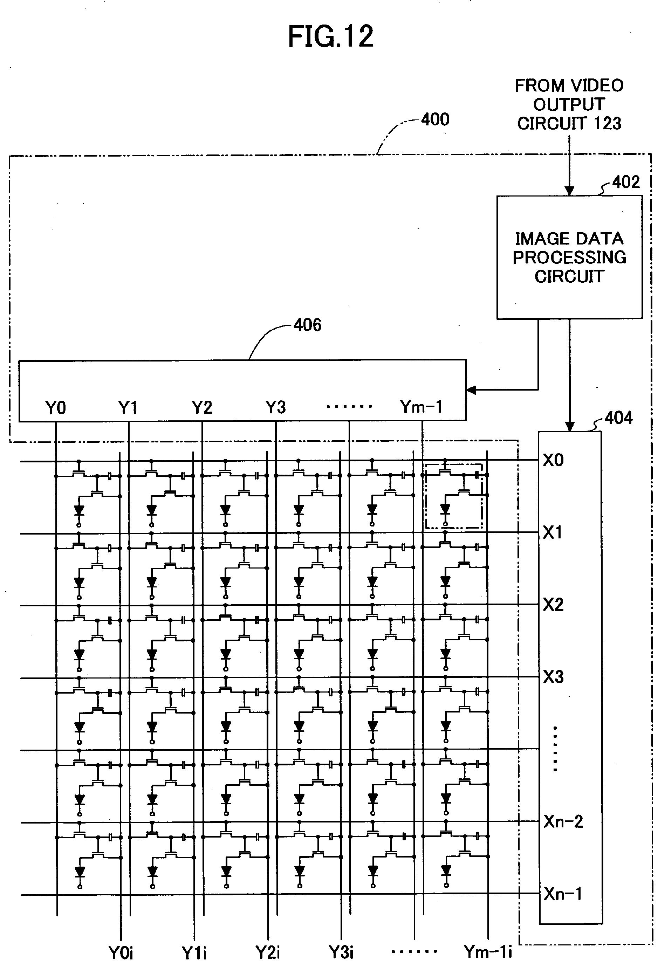

As shown in an example of FIG. 12, the display control apparatus 400 includes an image data process circuit 402, a scan line driver circuit 404, and a data line driver circuit 406.

The data processing circuit 402 determines luminance of the plural display elements 302 of the display 310 according to output signals of the video output circuit 123.

The scan line driver circuit 404 applies a voltage individually to the n scan lines according to instructions of the image data processing circuit 402.

The data line driver circuit 406 applies a voltage individually to the m data lines according to instructions of the image data processing circuit 402.

As is clear from the above description, the television apparatus 100 according to this embodiment has an image data forming apparatus formed of the video decoder 121, the video/OSD synthesizing circuit 122, the video output circuit 123, and the OSD drawing circuit 125.

As described above, according to this embodiment, the field effect transistor includes the gate electrode 26 for applying a gate voltage, a source electrode 23 and a drain electrode 24 for obtaining a current, an active layer 22 that is formed of an oxide semiconductor mainly formed of magnesium (Mg) and indium (In) and is provided adjacent to the source electrode 23 and the drain electrode 24, and the gate insulating layer 25 provided.between the gate electrode 26 and the active layer 22.

A flow rate of oxygen gas supplied when forming the active layer 22 is controlled so that the partial oxygen pressure becomes 1.7 × 10⁻³ Pa. An oxide semiconductor which constitutes the active layer 22 is a MgIn₂O₄ oxide semiconductor having volume resistivity of 10 Qcm and having a nonstoichiometric composition in regard to oxygen.

In this case, both high mobility and normally-off characteristic can be achieved.

Further, since the display element 302 according to this embodiment is provided with the field effect transistors 10 and 20, high speed drive can be achieved and variations among the elements can be reduced.

Further, since the image display device 124 includes the display element 302, a high quality image can be displayed by a large area display.

Further, since the television apparatus 100 according to this embodiment includes the image display device 124, image information can be displayed with a high definition.

In the above embodiment, the description has been made of the case where the organic EL thin film layer is formed of an electron transporting layer, a light emitting layer, and a hole transporting layer. However, the present invention is not limited to this. For example, the electron transporting layer and the light emitting layer may be formed as one layer. Moreover, an electron injecting layer may be provided between the electron transporting layer and the cathode. Furthermore, a hole injecting layer may be provided between the hole transporting layer and the anode.

In the above-described embodiment, a "bottom emission" type light emitting element, whereby light is emitted from the substrate side, has been described. However, the present invention is not limited to this. For example, light may be emitted from a side opposite to the substrate, by using a high reflective electrode such as a silver (Ag)-neodymium (Nd) alloy as the anode 314, and using a translucent electrode such as a magnesium (Mg)-silver (Ag) alloy or a transparent electrode such as ITO as the cathode 312.

Further, in the above embodiment, the organic EL element 350 is arranged beside the field effect transistor 20 in the display element 320. However, the present invention is not limited to this. For example, the organic EL element 350 may be provided over the field effect transistor 20 as shown in FIG. 13. In this case, the gate electrode 26 is required to be transparent. Therefore, a transparent oxide having conductivity, such as ITO, In₂O₃, SnO₂, ZnO, and ZnO to which Ga is doped, ZnO to which Al is doped, and SnO₂ to which Sb is doped, is used as the gate electrode 26.

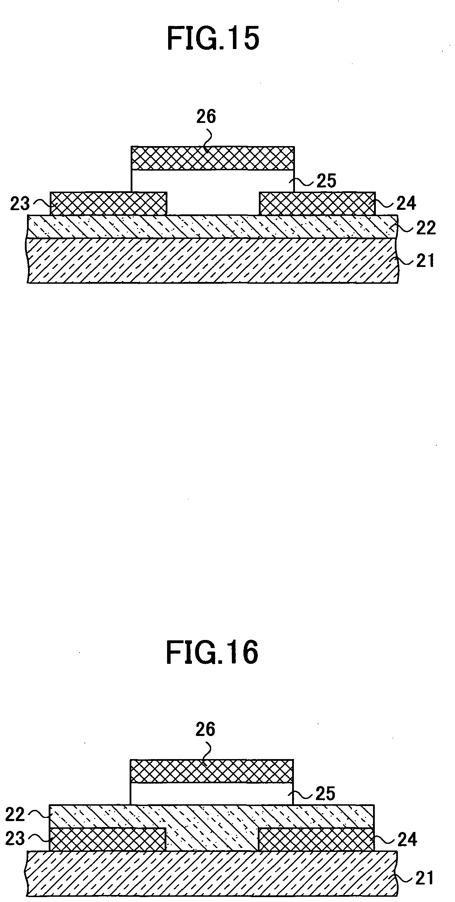

Further, in the above embodiment, the description has been made of the case where the field effect transistor is what is called a "top contact bottom gate type" transistor. However, the present invention is not limited to this. For example, as shown in FIG. 14, what is called a "bottom contact bottom gate type" transistor may be employed as well. Furthermore, as shown in FIG. 15, what is called a "top contact top gate type" transistor may be employed as well. Moreover, what is called a "bottom contact top gate type" transistor may be employed as shown in FIG. 16.

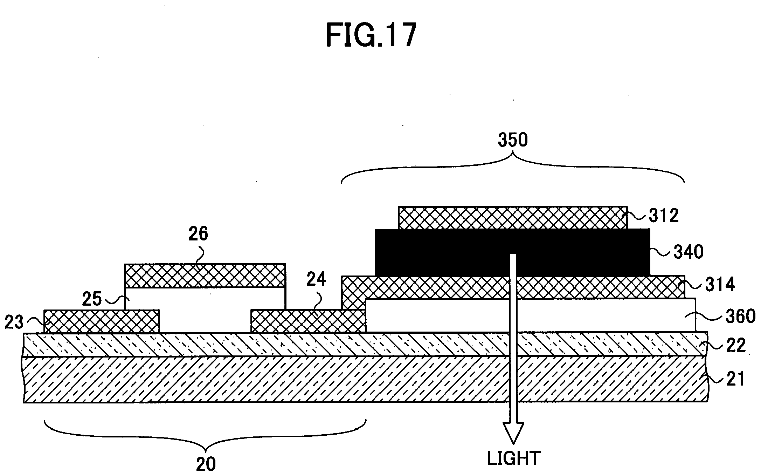

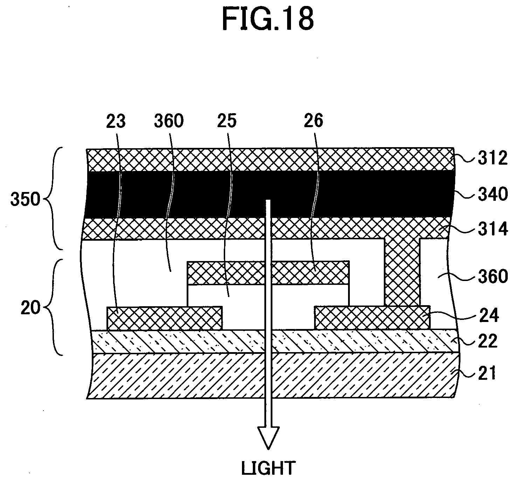

FIGS. 17 and 18 show examples of arrangements of the field effect transistor 20 and the organic EL element 350 in the case where the field effect transistor is a "top contact top gate type" transistor. Reference numeral 360 in FIGS. 17 and 18 denotes an insulating layer.

In the above embodiment, the description has been made of the case where the substrate 21 is a flat plate formed of glass. However, the present invention is not limited to this, and a flat plate formed of ceramics or plastic, or a plastic film may be used as the substrate 21 as well.

In the above embodiment, the description has been made of the case where each electrode is formed of aluminum (Al). However, the present invention is not limited to this. For example, each electrode may be formed of: a metal film formed solely of chromium (Cr), gold (Au), silver (Ag), tantalum (Ta), indium (In), molybdenum (Mo), tungsten (W), nickel (Ni), titanium (Ti), or the like; a metal stacked-layer film formed by stacking a plurality of these metal films; an alloy film including the above-described metal; a conductive oxide film such as In₂O₃, SnO₂, and ZnO; a conductive oxide film such as In₂O₃ (ITO) to which tin (Sn) is doped, ZnO to which gallium (Ga) is doped, ZnO to which aluminum (Al) is doped, and SnO₂ to which antimony (Sb) is added; or a film in which micro particles of the above-described material are dispersed.

In the above embodiment, the description has been made of the case where SiO₂ is used as the gate insulating layer 25. However, the present invention is not limited to this. For example, an oxide with an insulating property such as Al₂O₃, Ta₂O₅, Y₂O₃, La₂O₃, HfO₂, Nb₂O₃, and ZrO₂, an organic insulating material, and SiNx can be used as a material of the gate insulating layer 25.

Further, in the above embodiment, the oxide semiconductor that constitutes the active layer 22 is amorphous. However, the present invention is not limited to this. For example, the oxide semiconductor may have a spinel structure (including what is called an inverse spinel structure) or an olivine structure. Further, the oxide semiconductor that constitutes the active layer 22 may have both crystallinity and an amorphous property mixed in it. Moreover, the oxide semiconductor that constitutes the active layer 22 may include a phase having a spinel structure and a phase having an olivine structure mixed in it.

As a Modified example 1, a field effect transistor was manufactured in a manner similar to Embodiment 1 except that the partial oxygen pressure employed for sputtering the Mg-In oxide film was set at 2.7 × 10⁻³ Pa and the temperature of the substrate 21 was kept at 300°C. An X-ray diffraction measurementwas performed in a manner similar to the above-described embodiment with respect to the Mg-In oxide film formed over the glass substrate with the conditions of the Modified example 1. Then, plural peaks were observed. Specifically, the highest peak is obtained when 2θ is about 33°, which corresponds to a peak of MgIn₂O₄ (311) having the spinel structure. Accordingly, it was confirmed that a crystalline Mg-In oxide film was obtained by performing deposition while heating the substrate 21.

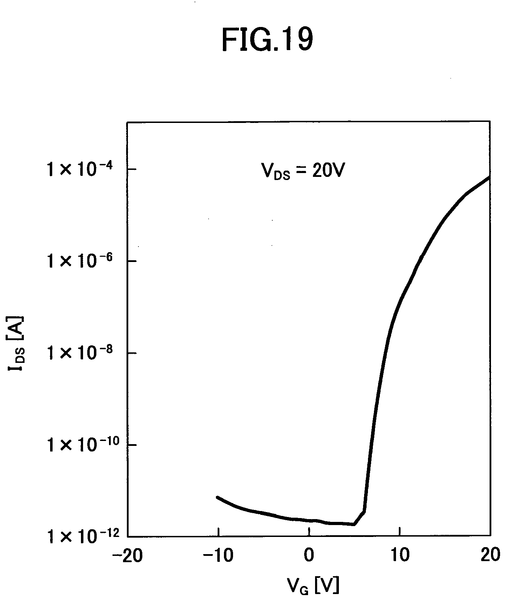

FIG. 19 shows a relationship between a gate voltage V_{G} and a source-drain current I_{DS} of the field effect transistor of Modified example 1 in the case where a source-drain voltage V_{DS} is 20 V. Accordingly, the source-drain current I_{DS} is a minimum value of 1.9 pA when the gate voltage V_{G} is 5 V, while I_{DS} = 63 µA when the gate voltage V_{G} is 20 V. Then, the field effect mobility calculated in the saturation region was 2.6 cm²/Vs. That is, the field effect transistor of the Modified example 1 achieves high carrier mobility and normally-off characteristic similarly to the field effect transistor of the above embodiment. The Mg-In oxide film formed with the conditions of the Modified example 1 had volume resistivity of 40 Ωcm.

In this case, the spinel structure is cubic, in which a one-dimensional chain (rutile chain) edge-shared by a BO₆ octahedron runs in various three-dimensional directions, and a AO₄ tetrahedron functions to connect the rutile chains. Transporting characteristics of the carriers do not depend on the orientation property of the thin film. That is, moving directions of the electrons are isotropic. Therefore, there is no disadvantage caused by the anisotropic property of the crystal structure, such as a ZnO semiconductor. Further, since a bottom part of a conduction band is constituted by a 5s orbital of indium, there is little effect of crystal grain boundaries with respect to the transporting characteristics of the electron carriers.

Moreover, in the oxide semiconductor constituting the active layer 22 in the above-described embodiment, a part of indium (In) may be substituted by at least one of aluminum (Al) and gallium (Ga). In this case, a band gap, energy of a bottom part of the conduction band, and lattice energy of oxygen atoms can be controlled by a species and a substitute amount of the substitution element. For example, when the substitute amount is increased, an ultraviolet transparent area can be enlarged. Moreover, when the substitute amount is increased, an energy level of a conduction band becomes higher, which makes it difficult to generate electron carriers.

As a Modified example 2, a field effect transistor was manufactured by a manufacturing method similar to Embodiment 1 except that-a Mg-In oxide film in which a part of indium (In) is substituted by gallium (Ga) was used as the active layer 22 and the oxygen partial pressure for sputtering the Mg-In oxide film was set at 1.8 × 10⁻³ Pa.

In this case, the Mg-In oxide film was formed by a simultaneous sputtering method using two targets (targets 1 and 2). The target 1 is a polycrystalline sintered body (with a diameter of 4 inches) having a composition of In₂MgO₄, and the target 2 is a polycrystalline sintered body (with a diameter of 4 inches) having a composition of Ga₂MgO₄. A sputtering power was set at 40 W with respect to In₂MgO₄, and 60 W with respect to Ga₂MgO₄, and thereby a Mg-In oxide film with a thickness of 100 nm was formed.

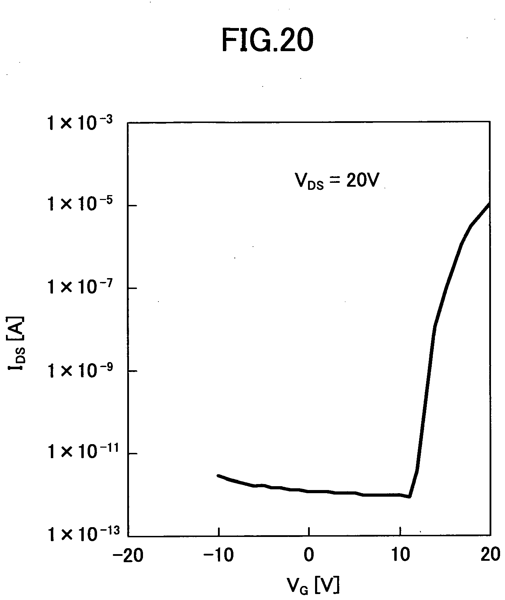

FIG. 20 shows a relationship between a gate voltage V_{G} and a source-drain current I_{DS} of the field effect transistor of the Modified example 2, in the case where a source-drain voltage V_{DS} is set at 20 V. According to FIG. 20, when the gate voltage V_{G} is set at 11 V, the source-drain current I_{DS} is a minimum value of 0.9 pA, while I_{DS} = 9.1 µA when the gate voltage V_{G} is 20 V. The field effect mobility calculated in the saturation region was 1.3 cm²/Vs. That is, high carrier mobility and normally-off, characteristic are achieved by the field effect transistor of the Modified example 2, similarly to the field effect transistor of the above embodiment. The Mg-In oxide film formed with the conditions of the Modified example 2 has volume resistivity of 1100 Qcm.

In the above embodiment, the oxide semiconductor constituting the active layer 22 has magnesium (Mg) partly substituted by at least one of calcium (Ca), strontium (Sr), and barium (Ba).

As a Modified example 3, a field effect transistor was manufactured in a manufacturing method similar to Embodiment 1, except that the Mg-In oxide film in which a part of magnesium (Mg) was substituted by strontium (Sr) was used as the active layer 22.

In this case, the Mg-In oxide film was formed by a simultaneous sputtering method using two targets (targets 1 and 2). The target 1 is a polycrystalline sintered body (with a diameter of 4 inches) having a composition of In₂MgO₄ while the target 2 is a polycrystalline sintered body (with a diameter of 4 inches) having a composition of In₂SrO₄. The Mg-In oxide film with a thickness of 100 nm was formed by setting a sputtering power at 200 W with respect to In₂MgO₄, and 30 W with respect to In₂SrO₄.

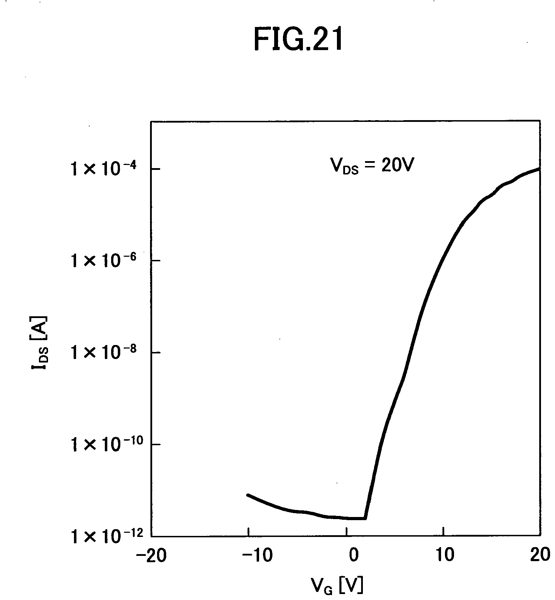

FIG. 21 shows a relationship between a gate voltage V_{G} and a source-drain current I_{DS} in the case where a source-drain voltage V_{DS} is 20 V in the field effect transistor of the Modified example 3. When the gate voltage V_{G} was 2 V, the source-drain current I_{DS} had a minimum value of 2 pA, while I_{DS} = 99 µA when V_{G} = 20 V. The field effect mobility calculated in the saturation region was 2.6 cm²/Vs. That is, the field effect transistor of Modified example 3 achieves high carrier mobility and normally-off characteristic similarly to the field effect transistors (10 and 20) of the above embodiment. The Mg-In oxide film formed with the conditions of the Modified example 3 had volume resistivity of 9 Ωcm.

As observed in an inverse spinel structure, trivalent cation (Y^{III}) can occupy a tetrahedral site and bivalent cation (X^{II}) can occupy an octahedral site. Composition ratios of the bivalent cation (Mg, Ca, Sr, Ba) and trivalent cation (In, Ga, Al) can be adjusted. A possible cation ratio X^{II}/Y^{III} is about 0.2 to 1. Cationic species and composition ratios can be appropriately selected by considering required TFT characteristics, a band gap (transparent region of ultraviolet light), stability of oxygen vacancy, a process tolerance (process margin), and the like.

In the above embodiment, the oxide semiconductor constituting the active layer 22 may have oxygen partly substituted by at least one of nitrogen and fluorine. In this case, an oxygen amount of the oxide semiconductor can be more precisely controlled.

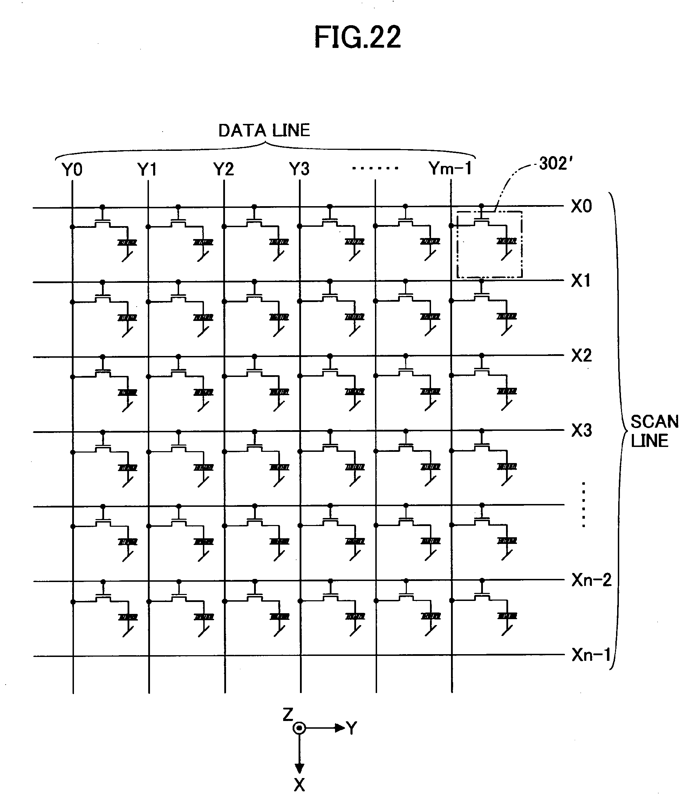

In the above embodiment, the description has been made of the case where the light control element is an organic EL element; however, the present invention is not limited to this. For example, a liquid crystal element may be used as the light control element, in which case the display 310 operates as a liquid crystal display. Moreover, as shown in FIG. 22 as an example, a current supply line for a display element 302' is not required.

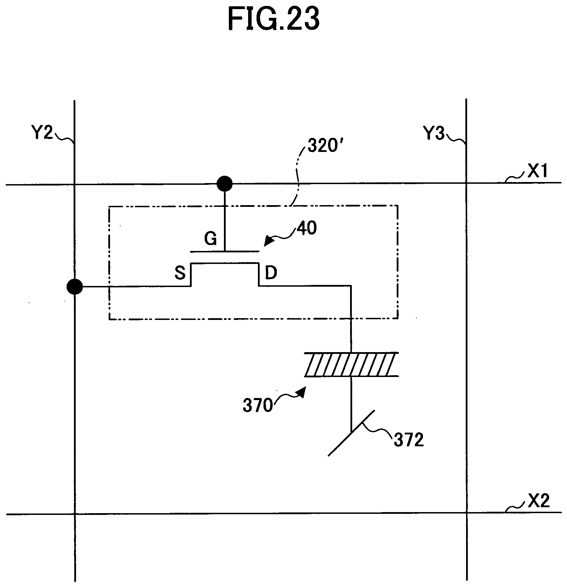

In this case, as shown in an example of FIG. 23, a driver circuit 320' can be constituted only by one field effect transistor 40 that is similar to the above-described field effect transistors (10 and 20). The field effect transistor 40 has a gate electrode G connected to a predetermined scan line, a source electrode S connected to a predetermined data line, and a drain electrode D connected to a pixel electrode of a liquid crystal element 370. A reference numeral 372 in FIG. 23 denotes a counter electrode (common electrode) of the liquid crystal element 370.

An inorganic EL element may be used as the light control element.

In the above embodiment, the description has been made of the color display; however, the present invention is not limited to this.

In the above embodiment, the description has been made of the case where the system is a television apparatus. However, the present invention is not limited to this. That is to say, it is only required that the image display device 124 be included as a device for displaying images and information. For example, a computer system, in which a computer (including a personal computer) and the image display device 124 are connected, may be employed as well.

The image display device 124 can be used as a display unit of portable information devices such as PDAs (Personal Digital Assistants), portable phones, portable music players, and portable movie players, and as a display unit of imaging devices such as still cameras and video cameras. Moreover, the image display device 124 can be used as a display unit for displaying various kinds of information in a mobile system of a vehicle, an airplane, a train, a ship and the like. Furthermore, the image display device 124 can be used as a display unit for displaying various kinds of information in a measurement apparatus, an analyzing apparatus, and a medical apparatus.

A field effect transistor of this embodiment can be used for components (for example, an IC (Integrated Circuit) card and an ID (Identification) tag) other than the display element.

As described above, the field effect transistor of the present invention is suitable for achieving high carrier mobility and normally-off characteristic. Further, the display element of the present invention is capable of high speed drive and is suitable for reducing variations among elements. Moreover, the image display device of the present invention is suitable for displaying high quality images with a large area screen. Furthermore, a system of the present invention is suitable for displaying image information with a high definition.

According to one embodiment, high carrier mobility and a normally-off characteristic can be achieved.

According to a field effect transistor of one embodiment, high speed drive can be performed and variations of elements can be reduced.

According to a display element of one embodiment, a high quality image can be displayed by a large area screen.

According to an image display device of one embodiment, image information can be displayed with a high definition.

## Claims

1. A field effect transistor (10, 20) comprising: a gate electrode (26) to which a gate voltage is applied; a source electrode (23) and a drain electrode (24) for obtaining a current in response to the gate voltage; an active layer (22) provided adjacent to the source electrode (23) and the drain electrode (24) and formed of an oxide semiconductor including MgIn₂O₄ with Mg partly substituted by at least one of Ca, Sr and Ba; and a gate insulating layer (25) provided between the gate electrode (26) and the active layer (22).

2. The field effect transistor (10, 20) as claimed in claim 1, wherein the oxide semiconductor has a volume resistivity of 10⁻² Ωcm to 10⁹ Ωcm.

3. The field effect transistor (10, 20) as claimed in claim 1, wherein the oxide semiconductor has at least a part that is amorphous.

4. A display element (302) comprising: a light control element (350) whose light output is controlled according to a driving signal; and a driver circuit (320) including the field effect transistor (10, 20) as claimed in claim 1 and configured to drive the light control element (350).

5. The display element (302) as claimed in claim 4, wherein the light control element (350) includes an organic electroluminescent element.

6. The display element (302) as claimed in claim 4, wherein the light control element (350) includes a liquid crystal element.

7. An image display device (124) for displaying an image according to image data, comprising: a plurality of the display elements (302) as claimed in claim 4 arranged in a matrix; a plurality of wires configured to apply a gate voltage individually to each of the field effect transistors (10, 20) of the plurality of display elements (302); and a display control device (400) configured to individually control the gate voltage applied to each of the field effect transistors (10, 20) through the plurality of wires according to the image data.

8. A system comprising: the image display device (310) as claimed in claim 7; and an image data forming device configured to form image data according to image information to be displayed and output the image data to the image display device (310).

## Patentansprüche

1. Feldeffekttransistor (10, 20), umfassend: eine Gate-Elektrode (26), an die eine Gate-Spannung angelegt ist, eine Source-Elektrode (23) und eine Drain-Elektrode (24) zum Erhalten eines Stroms als Reaktion auf die Gate-Spannung; eine aktive Schicht (22), die angrenzend an die Source-Elektrode (23) und die Drain-Elektrode (24) vorgesehen ist und aus einem Oxid-Halbleiter gebildet ist, der MgIn₂O₄ enthält, wobei Mg teilweise durch zumindest eines aus Ca, Sr und Ba ersetzt ist, und eine Gate-Isolierschicht (25), die zwischen der Gate-Elektrode (26) und der aktiven Schicht (22) vorgesehen ist.

2. Feldeffekttransistor (10, 20) nach Anspruch 1, wobei der Oxidhalbleiter einen spezifischen Volumenwiderstand von 10⁻² Dem bis 10⁹ Ωcm aufweist.

3. Feldeffekttransistor (10, 20) nach Anspruch 1, wobei der Oxidhalbleiter zumindest einen Teil aufweist, der amorphen ist.

4. Anzeigeelement (302), umfassend: ein Lichtsteuerungselement (350), dessen Lichtausgabe gemäß einem Ansteuersignal gesteuert wird; und eine Treiberschaltung (320), die den Feldeffekttransistor (10, 20) nach Anspruch 1 enthält und so konfiguriert ist, dass sie das Lichtsteuerungselement (350) antreibt.

5. Anzeigeelement (302) nach Anspruch 4, wobei das Lichtsteuerungselement (350) ein organisches Elektrolumineszenzelement enthält.

6. Anzeigeelement (302) nach Anspruch 4, wobei das Lichtsteuerungselement (350) ein Flüssigkristallelement enthält.

7. Bildanzeigevorrichtung (124) zum Anzeigen eines Bildes gemäß Bilddaten, umfassend: eine Vielzahl von Anzeigeelementen (302) nach Anspruch 4, die in einer Matrix angeordnet sind; eine Vielzahl von Drähten, die so konfiguriert sind, dass sie eine Gatespannung individuell an jeden der Feldeffekttransistoren (10, 20) der Vielzahl von Anzeigeelementen (302) anlegen; und eine Anzeigesteuerungsvorrichtung (400), die so konfiguriert ist, dass sie die an jeden der Feldeffekttransistoren (10, 20) angelegte Gatespannung über die Vielzahl von Drähten individuell gemäß den Bilddaten steuert.

8. System, umfassend: die Bildanzeigevorrichtung (310) nach Anspruch 7; und eine Bilddaten-Erzeugungsvorrichtung, die so konfiguriert ist, dass sie Bilddaten gemäß anzuzeigender Bildinformationen erzeugt und die Bilddaten an die Bildanzeigevorrichtung (310) ausgibt.

## Revendications

1. Transistor à effet de champ (10, 20) comprenant : une électrode de grille (26) à laquelle une tension de grille est appliquée ; une électrode de source (23) et une électrode de drain (24) pour obtenir un courant en réponse à la tension de grille ; une couche active (22) disposée adjacente à l'électrode de source (23) et à l'électrode de drain (24) et formée d'un oxyde semi-conducteur comprenant MgIn₂O₄ avec Mg partiellement substitué par au moins l'un parmi Ca, Sr et Ba ; et une couche isolante de grille (25) disposée entre l'électrode de grille (26) et la couche active (22).

2. Transistor à effet de champ (10, 20) selon la revendication 1, dans lequel l'oxyde semi-conducteur a une résistivité volumique de 10⁻² Ωcm à 10⁹ Ωcm.

3. Transistor à effet de champ (10, 20) selon la revendication 1, dans lequel l'oxyde semi-conducteur a au moins une partie amorphe.

4. Elément d'affichage (302) comprenant : un élément de commande de lumière (350) dont la sortie de lumière est commandée selon un signal de commande ; et un circuit d'entraînement (320) comprenant le transistor à effet de champ (10, 20) selon la revendication 1 et configuré pour entraîner l'élément de commande de lumière (350).

5. Elément d'affichage (302) selon la revendication 4, dans lequel l'élément de commande de lumière (350) comprend un élément électroluminescent organique.

6. Elément d'affichage (302) selon la revendication 4, dans lequel l'élément de commande de lumière (350) comprend un élément à cristaux liquides.

7. Dispositif d'affichage d'image (124) pour afficher une image selon des données d'image, comprenant : une pluralité d'éléments d'affichage (302) selon la revendication 4 disposés en matrice ; une pluralité de fils configurés pour appliquer une tension de grille individuellement à chacun des transistors à effet de champ (10, 20) de la pluralité d'éléments d'affichage (302) ; et un dispositif de commande d'affichage (400) configuré pour commander individuellement la tension de grille appliquée à chacun des transistors à effet de champ (10, 20) à travers la pluralité de fils conformément aux données d'image.

8. Système comprenant : le dispositif d'affichage d'image (310) selon la revendication 7 ; et un dispositif de formation de données d'image configuré pour former des données d'image selon des informations d'image à afficher et sortir les données d'image au dispositif d'affichage d'image (310).
